# EUROPEAN PATENT SPECIFICATION

(11) **EP 4 691 213 B1**
(45) Date of publication and mention of the grant of the patent: **07.10.2026**
(21) Application number: 24712585.9
(22) Date of filing: 12.03.2024
(51) Int. Cl.: H10N 50/10, H10N 50/80

(54) **CHIRAL SPIN-CURRENT SUPPLY STRUCTURE FOR MTJ-BASED MEMORY**
CHIRALE SPINSTROM-VERSORGUNGSSTRUKTUR FÜR MTJ-BASIERTEN SPEICHER
STRUCTURE D'ALIMENTATION EN COURANT DE SPIN CHIRAL POUR MÉMOIRE À BASE DE MTJ

(30) Priority: 24.03.2023 US 202318126127
(43) Date of publication of application: 11.02.2026
(73) Proprietor: International Business Machines Corporation, Armonk, New York 10504 (US)
(72) Inventor: SUN, Jonathan, Yorktown Heights, New York 10598 (US)
(74) Representative: IBM United Kingdom Limited
(86) International application number: PCT/IB2024/052365
(87) International publication number: WO 2024/201191

(56) References cited:
- US-A1- 2019 273 202
- US-A1- 2021 027 822
- US-A1- 2021 159 395
- SAFRANSKI CHRISTOPHER ET AL: "A perspective on electrical generation of spin current for magnetic random access memories", APPLIED PHYSICS LETTERS, AMERICAN INSTITUTE OF PHYSICS, 2 HUNTINGTON QUADRANGLE, MELVILLE, NY 11747, vol. 120, no. 16, 19 April 2022 (2022-04-19), XP012265117, ISSN: 0003-6951, [retrieved on 20220419], DOI: 10.1063/5.0084551
- SHAO QIMING ET AL: "Roadmap of Spin-Orbit Torques", IEEE TRANSACTIONS ON MAGNETICS, IEEE, USA, vol. 57, no. 7, 10 May 2021 (2021-05-10), pages 1 - 39, XP011862348, ISSN: 0018-9464, [retrieved on 20210622], DOI: 10.1109/TMAG.2021.3078583

## Description

### BACKGROUND

The present invention relates to a memory structure, and more particularly to a chiral spin-current supply structure for a two-terminal hybrid spin-orbit and magnetic tunnel spin-torque switched magnetic tunnel junction (SOT-MTJ) device.

There is a need for further reduction of write current in a magnetic tunnel junction (MTJ) used in spin-transfer torque magnetic random access memories (STT-MRAM), especially for applications in embedded memory technology requiring sub 10 ns switching. Since a device physics imposed minimum switching spin-current exists that is today practically on the order of 30-60 µA for approximately 10 ns speed switching in charge current unit, for further reduction of switching charge-current, better conversion to perpendicularly polarized spin-current from a charge current structure is necessary.

Spin-orbit torque (SOT) related charge-to-spin current conversion has shown feasibility for large charge to spin current conversion efficiency. However most materials' interface-crossing spin-current from spin-orbit action limits the spin-polarization in the plane of the interface the spin-current crosses. For most efficient spin-current driven magnetic switching utilizing the so-called "anti-damping" switching, it is desirable to have the spin-current polarization in the direction of the easy-axis for the switching magnet's moment. Since high density STT-MRAMs utilize MTJs with perpendicularly magnetized free layer (FL) moment, it is incompatible with an SOT-generated spin current whose polarization lies in the film-plane, making SOT generated spin-current difficult to use for STT-MRAM technology. Further, it is necessary to have high spin conductance between an SOT conductor and that of the ferromagnet one desires to switch, which often requires direct high quality interface contact between the SOT conductor and the ferromagnet that forms the magnetic free layer of the MTJ structure. When both are good electrical conductors, this could cause sizable charge current shunting, reducing the net charge-to-spin current conversion efficiency from the SOT.

A search has been under way for spin-conducting materials that are charge insulators, i.e., materials with large spin-conductance to charge-conductance ratio. Recent reports show sizable spin-current transport across 30 nm of NiO via magnon current, apparently with sufficient spin-conductance at high spin-current density (of the order of 10⁶ A/cm² charge-equivalent) to successfully demonstrate a spin-torque driven switching of a nanomagnet. Examples of conventional memory structures are described in: US 2021/159395 A1; SAFRANSKI CHRISTOPHER ET AL: "A perspective on electrical generation of spin current for magnetic random access memories", APPLIED PHYSICS LETTERS, vol. 120, no. 16, 19 April 2022, DOI: 10.1063/5.0084551; SHAO QIMING ET AL: "Roadmap of Spin-Orbit Torques", IEEE TRANSACTIONS ON MAGNETICS, IEEE, USA, vol. 57, no. 7, 10 May 2021 (2021-05-10), pages 1-39, DOI 10.1109/TMAG.2021.3078583; US 2021 /027822 A1; and US 2019/273202 A1.

Given this development, it is now feasible to contemplate a new class of hybrid SOT-MTJ spin-torque switching devices that simultaneously apply SOT and STT generated spin-current to the switching of a perpendicularly magnetized (PMA) nanomagnet, thereby combining their effect to further reduce switching current in a two-terminal STT-MTJ device.

### SUMMARY

A memory structure including a chiral spin-current supply structure is provided. In some embodiments, the chiral spin-current supply structure includes an inner core composed of a spin-collector material, a spin-conducting but charge insulating layer (hereinafter referred to as a spin-conducting insulator layer) surrounding the inner core, and a charge-current conducting spin-orbit spin-current generating layer surrounding the spin-conducting insulating layer. A magnetic tunnel junction structure is in contact with a horizontal surface of the inner core of the chiral spin-current supply structure.

The chiral spin-current supply structure of the present invention provides a chiral conduction path by geometry, whose spin current from a SOT layer (i.e., the charge-current conducting spin-orbit spin-current generating layer) with significantly perpendicular spin-polarization is generated via structural chiral selection and passes through a magnetic insulator (i.e., the spin-conducting insulating layer), and is brought to a surface for contact with a switching nanomagnet of the MTJ structure via a spin-current conductor. This structure leverages its geometry to simultaneously achieve three objectives: (1) it provides a perpendicularly polarized spin-current at the top surface; (2) its spin-current originates from the main contribution of SOT interfaces, as opposed to some higher order, usually weaker effects requiring special mirror-symmetry-breaking materials development; and (3) it prevents charge-current shunting, and therefore provides decoupling between spin current conversion efficiency and the SOT conductor total resistance.

In one aspect of the present invention, a memory structure is provided. In one embodiment, the memory structure includes a chiral spin-current supply structure including an inner core composed of a spin-collector material, a spin-conducting insulating layer surrounding the inner core, and a charge-current conducting spin-orbit spin-current generating layer surrounding the spin-conducting insulating layer; a magnetic tunnel junction (MTJ) structure having a magnetic free layer forming an interface with a surface of the inner core; and a charge current connection connecting the inner core to the charge-current conducting spin-orbit spin-current generating layer.

In some embodiments of the present invention, the spin-collector material is composed of a metal or metal alloy having a spin-conductance comparable to a good spin-conducting metal such as copper, with an effective spin conductivity of the order 1/(µΩ cm), and an interface resistance-area product of the order of less than 1 mΩ µm², both in equivalent charge resistivity units, and a spin-diffusion length of the order of 100 nm or longer at room temperature.

In some embodiments of the present invention, the spin-collector material includes, but is not limited to, Cu, Ag, Au or alloys thereof.

In some embodiments of the present invention, the spin-conducting insulating layer is composed of a magnetic insulator.

In some embodiments of the present invention, the magnetic insulator includes, but is not limited to, iron oxide (FeO_{X}), nickel oxide ((NiO), or YIG (Y₃Fe₅O₁₂).

In some embodiments of the present invention, the charge-current conducting spin-orbit spin-current generating layer includes a spin-orbit torque (SOT) channel material.

In some embodiments of the present invention, the SOT channel material includes, but is not limited to, β-Ta, β-W, Cu_{X}Pt_{1-X}, Cu_{1-X}Ta_{X}, Pd_{X}Pt_{1-X}, Au_{X}Pt_{1-X}, Pt, Bi₂Se₃, WTe₂, PtTe₂, TaS₂, Pt_{X}Rh_{1-X} or any materials known to produce large SOT-like charge-to-spin conversion, x is from 0 to 1, whose interface with the spin-conducting charge insulator may be further treated with an ultrathin (atomic thickness) "dusting" layer of spin-conducting material, including, but not limited to, Cu, Ag or Au.

In some embodiments of the present invention, the MTJ structure includes, from bottom to top, the magnetic free layer mentioned above, a magnetic tunnel barrier layer, a magnetic reference layer, and an electrode layer. In such embodiments, the MTJ structure is located on top of the chiral spin-current supply structure.

In some embodiments of the present invention, the MTJ structure includes, from bottom to top, an electrode layer, a magnetic reference layer, a magnetic tunnel barrier layer, and the magnetic free layer mentioned above. In such embodiments, the MTJ structure is located beneath the chiral spin-current supply structure.

In some embodiments of the present invention, the memory structure further includes an electrically conductive structure directly contacting a horizontal surface of the charge-current conducting spin-orbit spin-current generating layer.

In some embodiments of the present invention, the electrically conductive structure is located in an interconnect dielectric layer.

In some embodiments of the present invention, the spin-conducting insulating layer has an inner sidewall and an outer sidewall, wherein the inner sidewall of the spin-conducting insulating layer forms an interface with an outer sidewall of the inner core, and the outer sidewall of the spin-conducting insulating layer forms an interface with an inner sidewall of the charge-current conducting spin-orbit spin-current generating layer.

In some embodiments of the present invention, the outer sidewall of the inner core, the inner sidewall and the outer sidewall of the spin-conducting insulating layer, and the inner sidewall of the charge-current conducting spin-orbit spin-current generating layer are all significantly perpendicular (i.e., ± 10%) relative to a horizontal surface of an adjacent interconnect level.

In some embodiments of the present invention, the outer sidewall of the inner core, the inner sidewall and the outer sidewall of the spin-conducting insulating layer, and the inner sidewall of the charge-current conducting spin-orbit spin-current generating layer are all beveled relative to a horizontal surface of an adjacent interconnect level.

In some embodiments of the present invention, the charge-current conducting spin-orbit spin-current generating layer supports chiral charge current flow surrounding the inner core so as to generate a spin-current with spin polarization substantially out of the plane of the inner core's horizontal surface that contacts the MTJ structure.

In some examples, the MTJ structure has a first diameter, d₁, the inner core has a second diameter, d₂, the spin-conducting insulating layer has a third diameter, d₃, and the charge-current conducting spin-orbit spin-current generating layer has a fourth diameter, d₄, wherein d₁ is less than d₂, d₂ is less than d₃, and d₃ is less than d₄.

In some embodiments of the present invention, the charge current connection enables chiral charge current flow in the charge-current conducting spin-orbit spin-current generating layer.

In some examples, the charge current connection is a direct electrical contact structure.

In some embodiments of the present invention, the charge current connection is provided by a controlled amount of leakage current across the spin-conducting insulating layer from the inner core to the charge-current conducting spin-orbit spin-current generating layer, allowing an accumulation of current flow in the charge-current conducting spin-orbit spin-current generating layer to form a chiral charge current. In the present invention, the charge connection is in reference to the charge current connection between the inner core and the charge current conducting spin-orbit spin-current generating layer.

In some embodiments of the present invention, the charge-current conducting spin-orbit spin-current generating layer is electrically connected to a first terminal, and the MTJ structure is electrically connected to a second terminal.

In another embodiment, the memory structure includes a spin-collector material layer located in a recess of, and on top of, an interconnect dielectric layer, a spin-conducting insulating layer located on a sidewall of the spin-collector material layer, and a charge-current conducting spin-orbit spin-current generating layer located on the spin-conducting insulating layer; and a MTJ structure having a magnetic free layer forming an interface with a surface of the spin-collector material layer.

### BRIEF DESCRIPTION OF THE DRAWINGS

FIG. 1A is a cross sectional view of a chiral spin-current supply structure in accordance with an embodiment of the present invention.
FIG. 1B is a top down view of the chiral spin-current supply structure illustrated in FIG. 1A.
FIG. 2A is a cross sectional view of a memory structure that includes the chiral spin-current supply structure illustrated in FIG. 1A.
FIG. 2B is a top down view of the chiral spin-current supply structure illustrated in FIG. 2A.
FIG. 3 is a cross sectional view of a memory structure that includes a chiral spin-current supply structure in accordance with another embodiment of the present invention.
FIGS. 4A-4F are cross sectional views depicting a method that can be used in forming a chiral spin-current supply structure in accordance with the present invention.
FIG. 5A is a cross sectional view of a simplified memory structure in accordance with the present invention in the form of a straight, one-sidewall only layered SOT channel.
FIG. 5B is a top down view of the structure shown in FIG. 5A.

### DETAILED DESCRIPTION

The present invention will now be described in greater detail by referring to the following discussion and drawings that accompany the present description. It is noted that the drawings of the present description are provided for illustrative purposes only and, as such, the drawings are not drawn to scale. It is also noted that like and corresponding elements are referred to by like reference numerals.

In the following description, numerous specific details are set forth, such as particular structures, components, materials, dimensions, processing steps and techniques, in order to provide an understanding of the various embodiments of the present invention. However, it will be appreciated by one of ordinary skill in the art that the various embodiments of the present invention may be practiced without these specific details. In other instances, well-known structures or processing steps have not been described in detail in order to avoid obscuring the present description.

It will be understood that when an element as a layer, region or substrate is referred to as being "on" or "over" another element, it can be directly on the other element or intervening elements may also be present. In contrast, when an element is referred to as being "directly on" or "directly over" another element, there are no intervening elements present. It will also be understood that when an element is referred to as being "beneath" or "under" another element, it can be directly beneath or under the other element, or intervening elements may be present. In contrast, when an element is referred to as being "directly beneath" or "directly under" another element, there are no intervening elements present.

A started above, a chiral spin-current supply structure for use in a memory structure is provided. The chiral spin-current supply structure includes an inner core composed of a spin-collector material, a spin-conducting insulating layer surrounding the inner core, and a charge-current conducting spin-orbit spin-current generating layer surrounding the spin-conducting insulating layer. An MTJ structure is located on a horizontal surface of the inner core of the chiral spin-current supply structure. This structure leverages its geometry to simultaneously achieve three objectives: (1) it provides a perpendicularly polarized spin-current at the top surface; (2) its spin-current originates from the main contribution of SOT interfaces, as opposed to some higher order, usually weaker effects requiring special mirror-symmetry-breaking materials development; and (3) it prevents charge-current shunting, and therefore provides decoupling between spin current conversion efficiency and the SOT conductor total resistance.

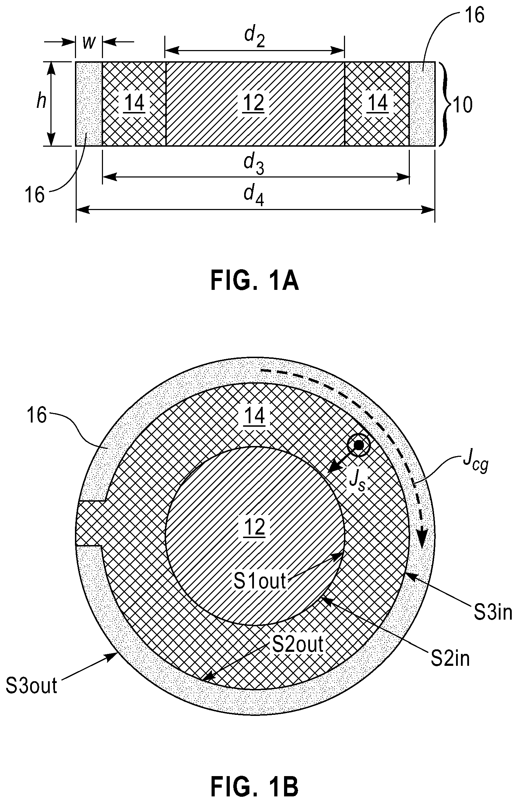

Referring first to FIGS. 1A-1B, there are illustrated a chiral spin-current supply structure 10 in accordance with an embodiment of the present invention. Notably, the chiral spin-current supply structure 10 illustrated in FIGS. 1A-1B includes an inner core 12 composed of a spin-collector material, a spin-conducting insulating layer 14 surrounding the inner core 12, and a charge-current conducting spin-orbit spin-current generating layer 16 surrounding the spin-conducting insulating layer 14. As is illustrated for the top-down view provided in FIG. 1B, the chiral spin-current supply structure 10 of the present invention is cylindrical in shape (i.e., disc shaped); although other shapes, notably those of rectangular or square shapes, may also be viable which are often more convenient to lithographically fabricate.

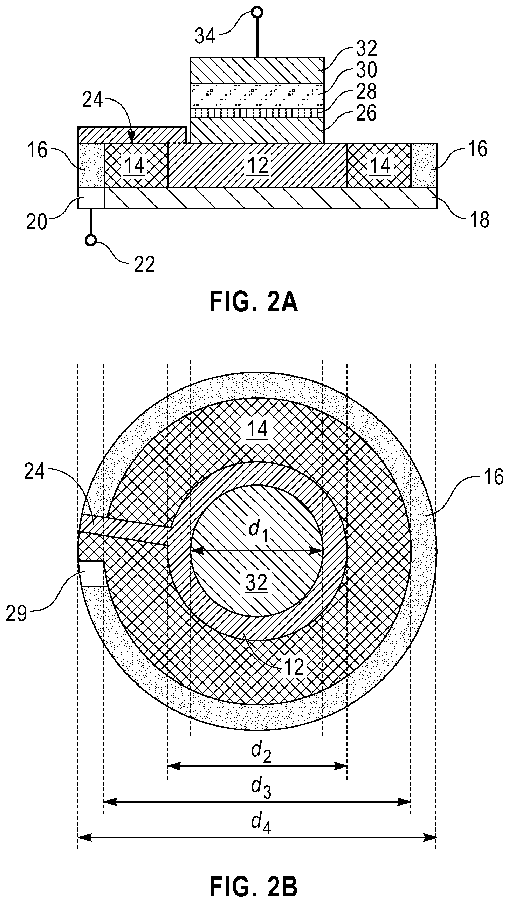

The inner core 12 is a solid structure having an outer sidewall, S1out, and a second diameter, d₂; the first diameter, d_{1,} is used in the present description to define the diameter of the MTJ structure (see, for example, FIG. 2B). In the present description, d₂ represents the diameter of the inner core that the MTJ structure is in contact with. The spin-conducting insulating layer 14 has an inner sidewall, S2in, an outer sidewall, S2out, and a third dimension, d_{3,} while the charge-current conducting spin-orbit spin-current generating layer 16 has an inner sidewall, S3in, an outer sidewall, S3out, and a fourth dimension, d₄. In the present description, the various diameters are as is shown in FIG. 1A or 2B.

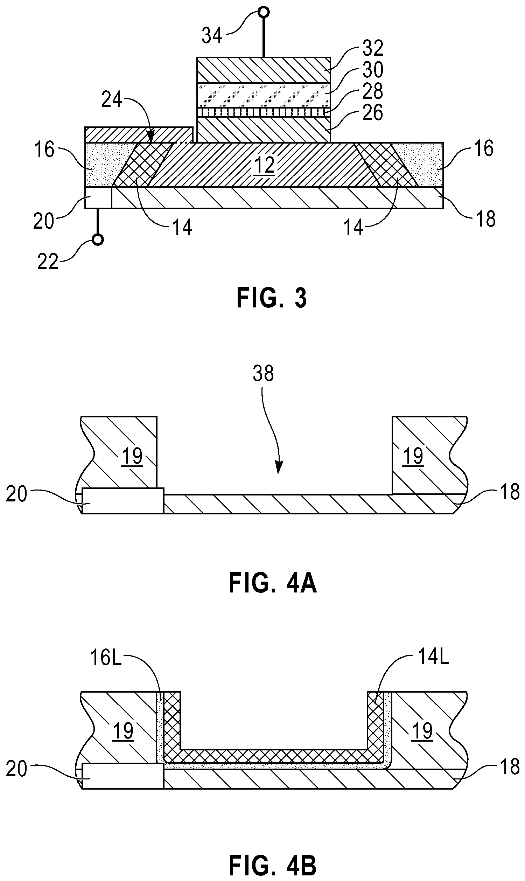

In embodiments, the inner sidewall, S2in, of the spin-conducting insulating layer 14 forms an interface with an outer sidewall, S1 out, of the inner core 12, and the outer sidewall, S2out, of the spin-conducting insulating layer 14 forms an interface with an inner sidewall, S3in, of the charge-current conducting spin-orbit spin-current generating layer 16. In this embodiment of the present invention, the outer sidewall, S1 out, of the inner core 12, the inner sidewall, S2in, and the outer sidewall, S2out, of the spin-conducting insulating layer 14, and the inner sidewall, S3in, (as well as the outer sidewall, S3out) of the charge-current conducting spin-orbit spin-current generating layer 16 are all substantially perpendicular (i.e., ± 10 %) relative to a horizontal surface of the substrate, i.e., the interconnect level 18/20 shown in FIGS. 2A. In some embodiments of the present invention, and as is illustrated in FIG. 3, the outer sidewall, S1out, of the inner core 12, the inner sidewall, S2in, and the outer sidewall, S2out, of the spin-conducting insulating layer 14, and the inner sidewall S3in, of the charge-current conducting spin-orbit spin-current generating layer 16 are all beveled (i.e., tapered) relative to a horizontal surface of the substrate, i.e., the interconnect level 18/20 shown in FIG. 3. The structure shown in FIG. 3 can mitigate fabrication challenges and can increase the contact area of the structure.

In the present description, d₁ is less than d_{2,} d₂ is less than d₃, and d₃ is less than d_{4.} The chiral spin-current supply structure 10 shown in FIG. 1A also has a height, h, and the charge-current conducting spin-orbit spin-current generating layer 16 has a width, w. In some embodiments, the height, h, can be from 10 nm to greater than 100 nm, and the width, w, can be from 1 nm to 10 nm. It is noted that the height range and width range mentioned herein are exemplary ranges and that other ranges can be used as appropriate.

Each component/element of the chiral spin-current supply structure 10 illustrated in FIGS. 1A-1B will now be described in greater detail; these elements are also applicable to the chiral spin-current supply structure 10 shown in FIGS. 2A-2B and FIG. 3. The inner core 12 of the chiral spin-current supply structure 10 is composed of a spin-collector material. The term "spin-collector material" is used throughout the present invention to define a metal or metal alloy that has a high spin-conductance and a long spin-diffusion length. One example of such a spin-collector material could be copper, with a spin-conductance of the order 1/(1*µ*Ω *cm*) in charge unit equivalence, and a spin-diffusion length greater than 100 nm at room temperature. The spin-collector materials exhibit a low spin loss. Exemplary spin-collector materials that can be used in the present invention, include, but are not limited to, Cu, Ag, Au or alloys thereof.

The spin-conducting insulating layer 14 of the chiral spin-current supply structure 10 is composed of a magnetic insulator. The magnetic insulators employed in the present invention as the spin-conducting insulating layer 14 are high spin-conducting materials that are also an insulator for charge conductance. Exemplary magnetic insulators that can be employed as the spin-conducting insulating layer 14 include, but are not limited to, FeO_{X}, NiO, or YIG (Y₃Fe₅O₁₂). The width of the spin-conducting insulating layer 14 that laterally surrounds the inner core 12 is typically from 1 nm to 10 nm, however, other widths can be used in the present invention as the width of the spin-conducting insulating layer 14.

The charge-current conducting spin-orbit spin-current generating layer 16 of the chiral spin-current supply structure 10 is composed of an SOT channel material. The SOT channel material employed in the present invention as the charge-current conducting spin-orbit spin-current generating layer 16 provides the necessary charge-to-spin conversion while carrying the same charge current through the MTJ structure. Exemplary SOT channel materials that can be employed herein as the charge-current conducting spin-orbit spin-current generating layer 16 include, but are not limited to, β-Ta, β-W, Cu_{X}Pt_{1-X}, Cu_{1-X}Ta_{X}, Pd_{X}Pt_{1-X}, Au_{X}Pt_{1-X}, Pt, Bi₂Se₃, WTe₂, PtTe₂, TaS₂, Pt_{X}Rh_{1-X} or any materials known to produce large SOT charge-to-spin conversion efficiency, where x is from 0 to 1. Other types of SOT-like channel materials that can be employed are the so-called orbital-moment generating alloys, such as CuOx/Pt or CuN/Pt. The charge-current conducting spin-orbit spin-current generating layer 16 that surrounds the spin-conducting insulating layer 14 has width, w, mentioned above.

It is noted that the charge-current conducting spin-orbit spin-current generating layer 16 supports chiral charge current flow surrounding the inner core 12 so as to generate a spin-current with spin polarization substantially out of the plane of the inner core's horizontal surface that contacts the MTJ structure. In this situation, the chirality (i.e. handedness) of charge-current flow in the charge-current conducting spin-orbit spin-current generating layer 16 surrounding both the spin-conducting insulating layer 14 and the inner core 12 forms the vectorial association between the charge current flowing direction and that of the resulting spin-current's spin-polarization direction.

It is noted that the spin-conducting insulating layer 14 forms a first interface with the inner core 12, and a second interface with the charge-current conducting spin-orbit spin-current generating layer 16. Both these interfaces are atomically clean interfaces. By "atomically clean interface" it is meant the interface is free of impurity elements, and can provide large interface conductance, of the order of 1/(1*m*Ω *µm*²) or thereabout in its area-specific interface conductance to spin-current in charge current equivalent units.

As is shown in FIG. 1B, the charge-current conducting spin-orbit spin-current generating layer 16 carries a charge current *J_{cg}* within its layer in circumferential direction, which generates a spin-current, *J_{S}* which propagates in radial direction through the spin-conducting insulating layer 14, and is collected by the inner core 12. The geometry of the chiral spin-current supply structure 10 permits a sidewall-parallel spin-polarization direction to align with the top surface norm of the spin-conductor material of the inner core 12, as is illustrated by the vector relationship of *J_{S}*, thus accomplishing a chiral-structure defined spin-polarization direction that is perpendicular to the inner core surface and ready to be delivered into a perpendicularly magnetized magnetic free layer 26 of a MTJ structure.

Although not shown in FIGS 1A-1B, the chiral spin-current supply structure 10 can be laterally surrounded by a dielectric material such as, for example, an interconnect dielectric material. The entire structure surrounding the chiral spin-current supply structure 10 can be chemical-mechanically polished to produce a smooth and chemically clean surface for growth of the MTJ layers above. This aspect of the present invention will be apparent from the process flow shown in FIGS. 4A-4F.

Referring now to FIGS. 2A-2B, there are illustrated a memory structure that includes the chiral spin-current supply structure 10 illustrated in FIGS. 1A-1B. Notably, the memory structure of the present invention is a two-terminal device that includes, in addition to the chiral spin-current supply structure 10, an interconnect level 18/20, and a MTJ structure 26/28/30/32. The interconnect level includes an electrically conductive structure 20 and an interconnect dielectric layer 18; the electrically conductive structure 20 is embedded in the interconnect dielectric layer 18 and can have a topmost surface that is coplanar with a topmost surface of the interconnect dielectric layer 18. As is illustrated in FIG. 2A, the electrically conductive structure 20 is in direct contact with a horizontal surface (i.e., bottommost surface) of the charge-current conducting spin-orbit spin-current generating layer 16. In the illustrated embodiment, the interconnect level 18/20 is located beneath the chiral spin-current supply structure 10, and the MTJ structure 26/28/30/32 is located above both the chiral spin-current supply structure 10 and the interconnect structure 18/20.

As is further shown, the charge-current conducting spin-orbit spin-current generating layer 16 is electrically connected to a first terminal 22 (via the electrically conductive structure 20) and the MTJ structure 26/28/30/32 is electrically connected to a second terminal 34 (via another electrically conductive structure (not specifically illustrated in the drawings)), The memory structure shown in FIGS. 2A-2B also includes a charge current connection (in the illustrated embodiment via a direct electrical contact structure 24) that connects the inner core 12 to the charge-current conducting spin-orbit spin-current generating layer 16.

The electrically conductive structure 20 that can be employed in the present description is composed of an electrically conductive metal or electrically conductive metal alloy. Illustrative examples of electrically conductive materials that can be used in the present description to provide the electrically conductive structure 20 include, but are not limited to, Cu, Al, Cu-Al alloy, W, Ru, or Rh. In some embodiments (not shown), a diffusion barrier liner can be present along at least a sidewall (and in some embodiments along a bottom wall) of the electrically conductive structure 20. When present, the diffusion barrier liner can be composed of any well-known diffusion barrier material such as, for example, Ta, TaN, Ti, TiN, W or WN. In some embodiments, the diffusion barrier liner can include a material stack of two or more diffusion barrier materials. In one example, the diffusion barrier liner can be composed of a stack of Ta/TaN or a stack of Ti/TiN.

Interconnect dielectric layer 18 is composed of any interconnect dielectric material including, for example, silicon oxide (SiOx), silsesquioxanes, C doped oxides (i.e., organosilicates) that includes atoms of Si, C, O and H, thermosetting polyarylene ethers, or multilayers thereof. The term "polyarylene" is used in this application to denote aryl moieties or inertly substituted aryl moieties which are linked together by bonds, fused rings, or inert linking groups such as, for example, oxygen, sulfur, sulfone, sulfoxide, carbonyl and the like. The interconnect dielectric layer 18 can have a dielectric constant (all dielectric constants mentioned herein are measured relative to a vacuum, unless otherwise stated) that is about 4.0 or less. In one embodiment, the interconnect dielectric layer 18 has a dielectric constant of 2.8 or less. These dielectrics generally having a lower parasitic cross talk as compared to dielectric materials whose dielectric constant is greater than 4.0.

The interconnect level 18/20 can be formed utilizing back-end-of-the-line (BEOL) techniques well known to those skilled in the art including, for example, deposition of the interconnect dielectric layer 18, followed by a damascene process that provides the electrically conductive structure 20. The interconnect dielectric layer 18 can be deposited by, for example, chemical vapor deposition (CVD), plasma enhanced chemical vapor deposition (PECVD) or spin-on coating.

The interconnect level 18/20 can be located above at least one underlying metal level (not shown) and a front-end-of-the-level (FEOL) also not shown. In some embodiments, the metal level can be a middle-of-the line (MOL) level. In other embodiments, the metal level can be at least one lower interconnect level of a multi-level interconnect structure. In yet further embodiments, the metal level can be a combination of a MOL level and at least one lower interconnect level of a multi-level interconnect structure. The metal level can include bottom electrically conductive structures embedded in a dielectric layer. The FEOL can include a semiconductor substrate having one or more semiconductor devices (such as, for example, transistors) formed thereon to provide logic and memory read/write functionalities. The metal level and the FEOL can be formed utilizing materials and techniques that are well known to those skilled in the art. So not to obscure the memory structure of the present application, the materials and techniques used in providing the metal level and the FEOL are not described in the present description.

In some embodiments and as is illustrated in FIG. 2A, the MTJ structure is a magnetic material-containing stack that includes, from bottom to top, a magnetic free layer 26, a magnetic tunnel barrier layer 28, a magnetic reference layer 30, and an electrode layer 32. In such an embodiment, the magnetic free layer 26 forms an interface with the inner core 12. In other embodiments derivable from FIGS. 2A and 3, but not shown, the entire structure could be inverted-- namely the MTJ structure could reside beneath the chiral spin-current generating structure 10, with the MTJ structure contacting the electrically conductive structure 20 that is positioned above the MTJ structure, while an edge of the chiral spin-orbit spin-current generating layer 16 would contact the second terminal 34, and with an inner core 12 to charge-current conducting spin-orbit spin-current generating layer 16 charge connection element 24 residing on the bottom of the chiral spin-current generating structure 10. In such embodiments, the MTJ structure would include, from bottom to top, electrode layer 32, magnetic reference layer 30, magnetic tunnel barrier layer 28, and magnetic free layer 26. The magnetic free layer 26 forms an interface with the inner core 12 that is now positioned above the MTJ structure.

The magnetic free layer 26 is composed of at least one magnetic material with a magnetization that can be changed in orientation relative to the magnetization orientation of the magnetic reference material. Exemplary materials for magnetic free layer 26 include, but are not limited to, alloys and/or multilayers of cobalt, iron, alloys of cobalt-iron, nickel, alloys of nickel-iron, and alloys of cobalt-iron-boron. The magnetic free layer 26 can have a thickness from 0.3 nm to 3 nm; although other thicknesses are possible and can be used as the thickness of the magnetic free layer 26.

The tunnel barrier layer 28 is composed of an insulator material and is formed at such a thickness as to provide an appropriate tunneling resistance. Exemplary insulator materials for the tunnel barrier layer 28 include, but are not limited to, magnesium oxide, aluminum oxide, and titanium oxide, or materials of higher electrical tunnel conductance, such as semiconductors or low-bandgap insulators. The thickness of the tunnel barrier layer 28 will depend on the material selected. In one example, the tunnel barrier layer 28 can have a thickness from 0.5 nm to 1.5 nm; although other thicknesses are possible as long as the thickness of the tunnel barrier layer 28 provides an appropriate tunneling resistance.

The magnetic reference layer 30 has a fixed magnetization. The magnetic reference layer 30 is composed of a metal or metal alloy that includes one or more metals exhibiting high spin polarization. In alternative embodiments, exemplary metals for the formation of the magnetic reference layer include iron, nickel, cobalt, chromium, boron, and manganese. Exemplary metal alloys can include the metals exemplified by the above. In another embodiment, the magnetic reference layer 30 can be a multilayer arrangement having (1) a high spin polarization interface with the tunnel barrier layer 28 formed of a metal and/or metal alloy using the metals mentioned above, and (2) a region constructed of a material or materials that exhibit strong perpendicular magnetic anisotropy (strong PMA). Exemplary materials with strong PMA that can be used include a metal such as cobalt, nickel, platinum, palladium, iridium, or ruthenium, and can be arranged as alternating layers. The strong PMA region can also include alloys that exhibit strong PMA, with exemplary alloys including cobalt-iron-terbium, cobalt-iron-gadolinium, cobalt-chromium-platinum, cobalt-platinum, cobalt-palladium, iron-platinum, and/or iron-palladium. The alloys can be arranged as alternating layers. In some embodiments, these alternating layers in the magnetic reference layer can be separated by exchange-coupling layers (such as Ru) so as to have oppositely aligned magnetization directions, forming the so-called synthetic antiferromagnets in order to reduce dipolar coupling between the magnetic reference layer and the magnetic free layer. In one embodiment, combinations of these materials and regions can also be employed. The magnetic reference layer 30 can have a thickness from 1 nm to 5 nm; although other thicknesses are possible and can be used as the thickness of the magnetic reference layer 30.

The electrode layer 32 is composed of an electrically conductive material such as, for example, Ta, TaN, Ti, TiN, Ru, RuN, RuTa, RuTaN, Co, CoWP, CoN, W, WN or any combination thereof. The electrode layer 32 can have a thickness from 5 nm to 100 nm; other thicknesses are possible and can be used in the present invention as the thickness of the electrode layer 32.

The MTJ structure of the present invention can be formed utilizing one or more deposition processes including, but not limited to, CVD, PECVD, PVD, ALD (including plasma enhanced ALD) or sputtering, followed by a patterning process that includes etching such as, for example, reactive ion etching (RIE) or ion beam etching.

In some embodiments, the direct electrical contact structure 24 typically includes one of the spin-collector materials mentioned above for inner core 12. In such embodiments, the spin-collector material that provides the direct electrical contact structure 24 can be compositionally the same as, or compositionally different from, the spin-collector material that provides the inner core 12. In FIG. 2A (and FIG. 3A), a dotted line below the electrical contact structure 24 is shown between the inner core 12 and the direct electrical contact structure 24. That dotted line represents a hypothetical material interface that can exist be present between the inner core 12 and the direct electrical contact structure 24. In other embodiments, the direct electrical contact structure 24 is composed of one of the electrically conductive materials mentioned above for the electrically conductive structure 20. The direct electrical contact structure 24 can be formed by deposition and lithographic patterning.

In some embodiments, the charge current connection is provided by a controlled amount of leakage current across the spin-conducting insulating layer 14 from the inner core 12 to the charge-current conducting spin-orbit spin-current generating layer 16, allowing an accumulation of current flow in the charge-current conducting spin-orbit spin-current generating layer 16 to form a chiral charge current. As long as the resistivity of the spin-conducting material 14 is much higher than those of the inner core 12 and the charge-current conducting spin-orbit spin-current generating layer 16, this leakage current would accumulate inside the charge-current conducting spin-orbit spin-current generating layer 16, and form a circumferential current flow that terminates into the electrically conductive structure 20, providing the necessary chirality definition of charge current flow pattern. The charge-current conducting spin-orbit spin-current generating layer 16 in this case would not need to be directly wired through a metal connection (element 24) to the inner core 12, although an electrically insulating gap remains necessary for the charge-current conducting spin-orbit spin-current generating layer 16 between its two edges (between contact edge 29 shown in FIG. 2B and the edge corresponding to the former metal connection 24).

Referring now to FIG. 3, there is illustrated a memory structure that includes a chiral spin-current supply structure 10 in accordance with another embodiment of the present invention. The chiral spin-current supply structure 10 employed in FIG. 3 includes elements/components as mentioned above for FIGS. 1A-1B. The chiral spin-current supply structure 10 employed in FIG. 3 is identical to the one employed in FIGS. 2A-2B except that in FIG. 3 the elements of the chiral spin-current supply structure 10 employed in FIG. 3 are beveled, i.e., tapered, as compared to those used in FIGS. 2A-2B. This tapering is usually formed during processing of the chiral spin-current supply structure 10. Such tapered edges are often easier to fabricate, and would not materially impact the efficiency of charge-to-spin current conversion efficiency, as long as the tapering angle is not substantially deviated from vertical.

Notably, the memory structure illustrated in FIG. 3 is a two-terminal device that includes, in addition to the chiral spin-current supply structure 10, interconnect level 18/20 (as described above in FIGS. 2A-2B), and MTJ structure 26/28/30/32 (as described above in FIGS. 2A-2B). The interconnect level includes electrically conductive structure 20 and interconnect dielectric layer 18, both as described above for the embodiment illustrated in FIGS. 2A-2B. As is illustrated in FIG. 3, the electrically conductive structure 20 is in direct contact with a horizontal surface (i.e., bottommost surface) of the charge-current conducting spin-orbit spin-current generating layer 16. This structure could be inverted as discussed above such that the chiral spin-current supply structure 10 and the interconnect level 18/20 are both located above the MTJ structure.

As is further shown in FIG. 3, the charge-current conducting spin-orbit spin-current generating layer 16 is electrically connected to first terminal 22 (via the electrically conductive structure 20) and the MTJ structure 26/28/30/32 is electrically connected to second terminal 34 (via another electrically conductive structure (not specifically illustrated in the drawings)). The memory structure shown in FIG. 3 also includes a charge current connection (via direct electrical contact structure 24) that connects the inner core 12 to the charge-current conducting spin-orbit spin-current generating layer 16.

Referring now to FIGS. 4A-4F, there are illustrated a method that can be used in forming a chiral spin-current supply structure in accordance with the present invention. The method depicted in FIGS. 4A-4F represents one method that can be employed. Other methods however readily apparent from the processing flow shown in FIGS. 4A-4F can be employed also be employed.

Reference is first made to FIG. 4A, which shows an exemplary structure that includes a patterned dielectric layer 19 located on a surface of an interconnect level that includes electrically conductive structure 20 embedded in interconnect dielectric layer 18. This interconnect level 18/20 can be formed as described above. The patterned dielectric layer 19 includes one of the interconnect dielectric materials mentioned above for the interconnect dielectric layer 18. The interconnect dielectric material that provides the patterned dielectric layer 19 can be compositionally the same as, or compositionally different from, the interconnect dielectric material that provides the interconnect dielectric layer 18. The patterned dielectric layer 19 includes opening 38 formed therein.; more than one opening can be formed. The opening 38 physically exposes a portion of the underlying electrically conductive structure 20 and a portion of the underlying interconnect dielectric layer 18. The patterned dielectric layer 19 can be formed by deposition (e.g., CVD, PECVD or spin-on coating) of an interconnect dielectric material, followed by lithographic patterning.

Next, and as is shown in FIG. 4B, a SOT channel layer 16L and a magnetic insulator layer 14L are formed in opening 38. The SOT channel layer 16L includes one of the SOT channel materials mentioned above and it will be used in providing the charge-current conducting spin-orbit spin-current generating layer 16. The magnetic insulator layer 14L includes one of the magnetic insulator materials mentioned above and will be used in providing the spin-conducting insulating layer 14. Both the SOT channel layer 16L and the magnetic insulator layer 14L can be formed by a relatively conformal sidewall deposition process. Some tapering of the SOT channel layer 16L and the magnetic insulator layer 14L can occur during this step.

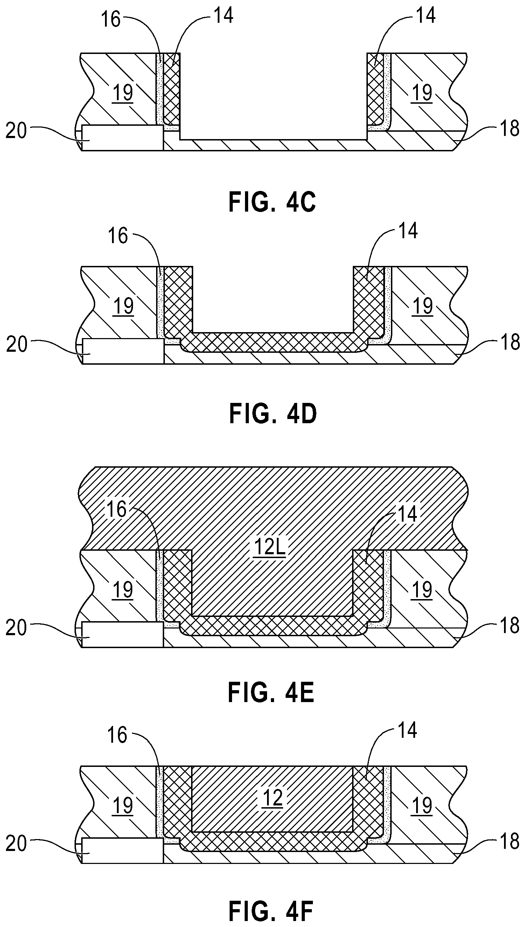

Next, and as is shown in FIG. 4C, a directional etching process such as, for example, a direction ion beam etch, can be used to remove the magnetic insulator layer 14L and the SOT channel layer 16L from the bottom of the opening 38. In some embodiments, the directional etching process can also remove an upper portion of the interconnect dielectric layer. After directional etching, a portion of the magnetic insulator layer 14L and a portion of the SOT channel layer 16L remain in the opening and along the sidewalls of the dielectric layer 19. The remaining portion of the SOT channel layer 16L can be referred to herein as the charge-current conducting spin-orbit spin-current generating layer 16, and a remaining portion of the magnetic insulator layer 14L can be referred to herein as the spin-conducting insulating layer 14.

Next, and as is shown in FIG. 4D, if necessary, additional magnetic insulator material can be formed to provide a magnetic insulator layer 14L that has a bottommost portion. The additional magnetic insulator material is compositionally the same as the magnetic insulator used in providing magnetic insulator layer 14L. The additional magnetic insulator can be formed by deposition such as, for example, CVD, PECVD, physical vapor deposition (PVD) or atomic layer deposition (ALD). This step can be omitted in some embodiments.

Next, and as is shown in FIG. 4E, a spin-collector layer 12L is formed by a deposition process such as, for example, CVD, PECVD, PVD, ALD, or sputtering. The spin-collector layer 12L is a layer that is formed inside and outside of the opening 38. The spin-collector layer 12L includes one of the spin-collector materials mentioned above and is employed in forming the inner core 12 of the chiral spin-current supply structure.

Next, and as is shown in FIG. 4F, a planarization process such as, for example, chemical mechanical polishing (CMP), can be used to remove the overburdened portion of the spin-collector layer 12L that is formed outside of opening 38 and on top of the dielectric layer 19. After planarization, a portion of the spin-collector layer 12L remains in the opening 38. This remaining portion of the spin-collector layer 12L provides inner core 12 of the chiral spin-current supply structure 10 of the present invention.

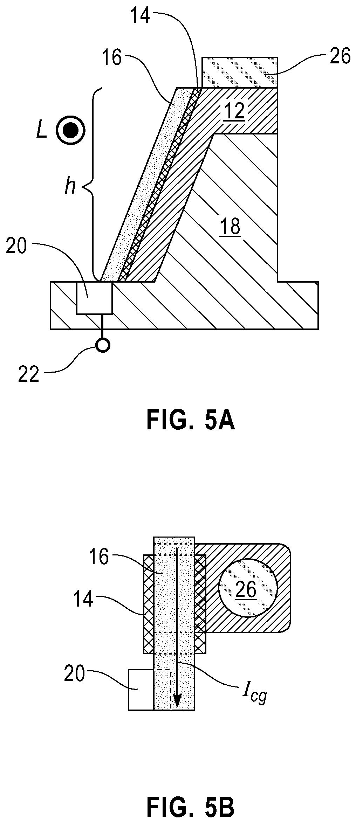

Reference is now made to FIGS. 5A-5B, which illustrate various views of a simplified memory structure in accordance with the present invention in the form of a straight, one-sidewall only layered SOT channel. In these drawings, the structure includes interconnect dielectric layer 18 (including, for example, one of the interconnect dielectrics mentioned above) to having a tapered sidewall in which a chiral spin-current supply structure is located thereon. The chiral spin-current supply structure includes a layer of spin-collector material as the inner core 12, spin-conducting insulating layer 14, and charge-current conducting spin-orbit spin-current generating layer 16. A magnetic free layer 26 of an MTJ structure forms and interface with a surface of the spin-collector material. In FIG 5A, h denotes the height of the chiral spin-current supply structure, and L denotes the sidewall length in a direction coming out of the drawing sheet. In FIG. 5B, I_{cg} is the charge current flowing through the charge-current conducting spin-orbit spin-current generating layer 16, from inner core 12 to the via contact (i.e., the electrically conductive structure 20) in interconnect dielectric layer 18. The structure illustrated in FIGS. 5A-5B could be fabricating with existing fabrication tools, with sidewall covering deposition of a magnetic insulator and a SOT channel material by substantially conformal deposition methods such as sputtering, chemical vapor deposition (CVD), or atomic layer deposition (ALD) onto the sidewall structure.

The present invention has been described and illustrated with reference to preferred embodiments. However, it will be understood by those skilled in the art that modifications and variations in form and detail may be made without departing from scope of the invention. Therefore, the present invention is solely defined by the scope of the appended claims.

## Claims

1. A memory structure comprising:
a chiral spin-current supply structure (10) comprising an inner core (12) composed of a spin-collector material, a spin-conducting insulating layer (14) surrounding the inner core, and a charge-current conducting spin-orbit spin-current generating layer (16) surrounding the spin-conducting insulating layer;
a magnetic tunnel junction, MTJ, structure (26, 28, 30, 32) having a magnetic free layer (26) forming an interface with a surface of the inner core; and
a charge current connection (24) connecting the inner core to the charge-current conducting spin-orbit spin-current generating layer.

2. The memory structure of Claim 1, wherein the spin-collector material is composed of a metal or metal alloy having a spin-conductance and spin-diffusion length comparable to high-quality copper.

3. The memory structure of Claim 2, wherein the spin-collector material comprises Cu, Ag, Au or alloys thereof.

4. The memory structure of Claim 1, wherein the spin-conducting insulating layer is composed of a magnetic insulator.

5. The memory structure of Claim 4, wherein the magnetic insulator comprises iron oxide, nickel oxide, or Y₃Fe₅O₁₂.

6. The memory structure of Claim 1, wherein the charge-current conducting spin-orbit spin-current generating layer comprises a spin-orbit torque, SOT, channel material.

7. The memory structure of Claim 6, wherein the SOT channel material comprises β-Ta, β-W, Cu_{X}Pt_{1-X}, Cu_{1-X}Ta_{X}, Pd_{X}Pt_{1-X}, Au_{X}Pt_{1-X}, Pt, Bi₂Se₃, WTe₂, PtTe₂, TaS₂, Pt_{X}Rh_{1-X}, wherein x is from 0 to 1.

8. The memory structure of Claim 1, wherein the MTJ structure comprises, from one of bottom to top and top to bottom, the magnetic free layer, a magnetic tunnel barrier layer (28), a magnetic reference layer (30), and an electrode layer (32).

9. The memory structure of Claim 1, further comprising an electrically conductive structure (20) directly contacting a horizontal surface of the charge-current conducting spin-orbit spin-current generating layer, wherein the electrically conductive structure is located in an interconnect dielectric layer (18).

10. The memory structure of Claim 1, wherein the spin-conducting insulating layer has an inner sidewall (S2in) and an outer sidewall (S2out), wherein the inner sidewall of the spin-conducting insulating layer forms an interface with an outer sidewall (S1out) of the inner core, and the outer sidewall of the spin-conducting insulating layer forms an interface with ar inner sidewall (S3in) of the charge-current conducting spin-orbit spin-current generating layer; and, wherein the outer sidewall of the inner core, the inner sidewall and the outer sidewall of the spin-conducting insulating layer, and the inner sidewall of the charge-current conducting spin-orbit spin-current generating layer are all one of bevelled and perpendicular relative to a horizontal surface of an adjacent interconnect level.

11. The memory structure of Claim 1, wherein the charge-current conducting spin-orbit spin-current generating layer supports chiral charge current flow surrounding the inner core so as to generate a spin-current with spin polarization substantially out of the plane of the inner core's horizontal surface that contacts the MTJ structure.

12. The memory structure of Claim 1, wherein the charge current connection between the inner core and the charge-current conducting spin-orbit spin-current generating layer enables chiral charge current flow in the charge-current conducting spin-orbit spin-current generating layer.

13. The memory structure of Claim 1, wherein the charge current connection between the inner core and the charge-current conducting spin-orbit spin-current generating layer is provided by a controlled amount of leakage current across the spin-conducting insulating layer from the inner core to the charge-current conducting spin-orbit spin-current generating layer, allowing an accumulation of current flow in the charge-current conducting spin-orbit spin-current generating layer to form a chiral charge current.

14. The memory structure of Claim 1, the charge-current conducting spin-orbit spin-current generating layer is electrically connected to a first terminal (22), and the MTJ structure is electrically connected to a second terminal (34).

15. A memory structure comprising:
a spin-collector material layer (12) located in a recess (38) and on top of an interconnect dielectric layer (18), a spin-conducting insulating layer (14) located on a sidewall of the spin-collector material layer, and a charge-current conducting spin-orbit spin-current generating layer (16) located on the spin-conducting insulating layer; and a MT structure having a magnetic free layer (26) forming an interface with a surface of the spin-collector material layer

## Patentansprüche

1. Speicherstruktur, aufweisend:
eine chirale Spinstrom-Versorgungsstruktur (10), welche einen inneren Kern (12), der aus einem Spin-Kollektor-Material aufgebaut ist, eine Spin-leitende isolierende Schicht (14), die den inneren Kern umgibt, und eine Ladestrom-leitende Spin-Orbit-Spinstrom-Erzeugungsschicht (16) aufweist, die die Spin-leitende isolierende Schicht umgibt;
eine Struktur eines magnetischen Tunnelübergangs, Magnetic Tunnel Junction, MTJ-Struktur (26, 28, 30, 32), mit einer magnetisch freien Schicht (26), welche eine Grenzfläche mit einer Fläche des inneren Kerns bildet; und
eine Ladestromverbindung (24), welche den inneren Kern mit der Ladestrom-leitenden Spin-Orbit-Spinstrom-Erzeugungsschicht verbindet.

2. Speicherstruktur nach Anspruch 1, wobei das Spin-Kollektor-Material aus einem Metall oder einer Metalllegierung mit einer Spin-Leitfähigkeit und einer Spin-Diffusionslänge aufgebaut ist, die mit Kupfer hoher Qualität vergleichbar sind.

3. Speicherstruktur nach Anspruch 2, wobei das Spin-Kollektor-Material Cu, Ag, Au oder Legierungen davon aufweist.

4. Speicherstruktur nach Anspruch 1, wobei die Spin-leitende isolierende Schicht aus einem magnetischen Isolator aufgebaut ist.

5. Speicherstruktur nach Anspruch 4, wobei der magnetische Isolator Eisenoxid, Nickeloxid oder Y₃Fe₅O₁₂ aufweist.

6. Speicherstruktur nach Anspruch 1, wobei die Ladestrom-leitende Spin-Orbit-Spinstrom-Erzeugungsschicht ein Spin-Orbit-Torque-Kanalmaterial, SOT-Kanalmaterial, aufweist.

7. Speicherstruktur nach Anspruch 6, wobei das SOT-Kanalmaterial ß-Ta, ß-W, CuₓPt₁₋ₓ, Cu₁₋ₓTaₓ, PdₓPt₁₋ₓ, AuₓPt₁₋ₓ, Pt, Bi₂Se₃, WTe₂, PtTe₂, TaS₂, PtₓRh₁₋ₓ aufweist, wobei x 0 bis 1 beträgt.

8. Speicherstruktur nach Anspruch 1, wobei die MTJ-Struktur von unten nach oben oder von oben nach unten die magnetisch freie Schicht, eine Schicht einer magnetischen Tunnelbarriere (28), eine magnetische Referenzschicht (30), und eine Elektrodenschicht (32) aufweist.

9. Speicherstruktur nach Anspruch 1, welche ferner eine elektrisch leitfähige Struktur (20) aufweist, die direkt eine horizontale Fläche der Ladestrom-leitenden Spin-Orbit-Spinstrom-Erzeugungsschicht kontaktiert, wobei die elektrisch leitfähige Struktur in einer dielektrischen Verbindungsschicht (18) angeordnet ist.

10. Speicherstruktur nach Anspruch 1, wobei die Spin-leitende isolierende Schicht eine innere Seitenwand (S2in) und eine äußere Seitenwand (S2out) aufweist,
wobei die innere Seitenwand der Spin-leitenden isolierenden Schicht eine Grenzfläche mit einer äußeren Seitenwand (S1out) des inneren Kerns bildet und die äußere Seitenwand der Spin-leitenden isolierenden Schicht eine Grenzfläche mit einer inneren Seitenwand (S3in) der Ladestrom-leitenden Spin-Orbit-Spinstrom-Erzeugungsschicht bildet; und wobei die äußere Seitenwand des inneren Kerns, die innere Seitenwand und die äußere Seitenwand der Spin-leitenden isolierenden Schicht und die innere Seitenwand der Ladestrom-leitenden Spin-Orbit-Spinstrom-Erzeugungsschicht alle entweder stumpfwinklig oder senkrecht in Bezug auf eine horizontale Fläche einer benachbarten Verbindungsebene sind.

11. Speicherstruktur nach Anspruch 1, wobei die Ladestrom-leitende Spin-Orbit-Spinstrom-Erzeugungsschicht einen Fluss eines chiralen Ladestroms um den inneren Kern unterstützt, um einen Spinstrom mit einer Spinpolarisation im Wesentlichen aus der Ebene der horizontalen Fläche des inneren Kerns heraus, welche mit der MTJ-Struktur in Kontakt steht, zu erzeugen.

12. Speicherstruktur nach Anspruch 1, wobei die Ladestromverbindung zwischen dem inneren Kern und der Ladestrom-leitenden Spin-Orbit-Spinstrom-Erzeugungsschicht einen Fluss eines chiralen Ladestroms in der Ladestrom-leitenden Spin-Orbit-Spinstrom-Erzeugungsschicht ermöglicht.

13. Speicherstruktur nach Anspruch 1, wobei die Ladestromverbindung zwischen dem inneren Kern und der Ladestrom-leitenden Spin-Orbit-Spinstrom-Erzeugungsschicht durch eine kontrollierte Menge an Leckstrom durch die Spin-leitende isolierende Schicht von dem inneren Kern zu der Ladestrom-leitenden Spin-Orbit-Spinstrom-Erzeugungsschicht bereitgestellt wird, wodurch eine Anhäufung von Stromfluss in der Ladestrom-leitenden Spin-Orbit-Spinstrom-Erzeugungsschicht ermöglicht wird, um einen chiralen Ladestrom zu bilden.

14. Speicherstruktur nach Anspruch 1, die Ladestrom-leitende Spin-Orbit-Spinstrom-Erzeugungsschicht ist elektrisch mit einem ersten Anschluss (22) verbunden und die MTJ-Struktur ist elektrisch mit einem zweiten Anschluss (34) verbunden.

15. Speicherstruktur, aufweisend:
eine Schicht eines Spin-Kollektor-Materials (12), welche in einer Aussparung (38) und oben auf einer dielektrischen Verbindungsschicht (18) angeordnet ist, eine Spin-leitende isolierende Schicht (14), welche an einer Seitenwand der Schicht des Spin-Kollektor-Materials angeordnet ist, und eine Ladestrom-leitende Spin-Orbit-Spinstrom-Erzeugungsschicht (16), welche auf der Spin-leitenden isolierenden Schicht angeordnet ist; und eine MTJ-Struktur mit einer magnetisch freien Schicht (26), welche eine Grenzfläche mit einer Fläche der Schicht des Spin-Kollektor-Materials bildet.

## Revendications

1. Structure de mémoire comprenant :
une structure d'alimentation en courant de spin chiral (10) comprenant un noyau interne (12) composé d'un matériau collecteur de spin, une couche isolante conductrice de spin (14) entourant le noyau interne et une couche conductrice de courant de charge et génératrice de courant de spin par effet spin-orbite (16) entourant la couche isolante conductrice de spin ;
une structure de jonction à effet tunnel magnétique, MTJ, (26, 28, 30, 32) ayant une couche libre magnétique (26) formant une interface avec une surface du noyau interne ; et
une connexion de courant de charge (24) connectant le noyau interne à la couche conductrice de courant de charge et génératrice de courant de spin par effet spin-orbite.

2. Structure de mémoire selon la revendication 1, dans laquelle le matériau collecteur de spin est composé d'un métal ou d'un alliage métallique ayant une conductance de spin et une longueur de diffusion de spin comparable au cuivre de qualité élevée.

3. Structure de mémoire selon la revendication 2, dans laquelle le matériau collecteur de spin comprend du Cu, de l'Ag, de l'Au ou des alliages de ceux-ci.

4. Structure de mémoire selon la revendication 1, dans laquelle la couche isolante conductrice de spin est composée d'un isolant magnétique.

5. Structure de mémoire selon la revendication 4, dans laquelle l'isolant magnétique comprend de l'oxyde de fer, de l'oxyde de nickel ou Y₃Fe₅O₁₂.

6. Structure de mémoire selon la revendication 1, dans laquelle la couche conductrice de courant de charge et génératrice de courant de spin par effet spin-orbite comprend un matériau de canal de couple spin-orbite, SOT.

7. Structure de mémoire selon la revendication 6, dans laquelle le matériau de canal de SOT comprend du ß-Ta, ß-W, CuₓPt₁₋ₓ, Cu₁₋ₓTaₓ, PdₓPt₁₋ₓ, de l'AuₓPt₁₋ₓ, Pt, du Bi₂Se₃, WTe₂, PtTe₂, TaS₂, PtₓRh₁₋ₓ, où x varie de 0 à 1.

8. Structure de mémoire selon la revendication 1, dans laquelle la structure de MTJ comprend, de bas en haut et de haut en bas, la couche libre magnétique, une couche barrière de tunnel magnétique (28), une couche de référence magnétique (30) et une couche d'électrode (32).

9. Structure de mémoire selon la revendication 1, comprenant en outre une structure électriquement conductrice (20) en contact direct avec une surface horizontale de la couche conductrice de courant de charge et génératrice de courant de spin par effet spin-orbite, dans laquelle la structure électriquement conductrice est située dans une couche diélectrique d'interconnexion (18).

10. Structure de mémoire selon la revendication 1, dans laquelle la couche isolante conductrice de spin possède une paroi latérale interne (S2in) et une paroi latérale externe (S2out),
dans laquelle la paroi latérale interne de la couche isolante conductrice de spin forme une interface avec une paroi latérale externe (S1out) du noyau interne, et la paroi latérale externe de la couche isolante conductrice de spin forme une interface avec une paroi latérale interne (S3in) de la couche conductrice de courant de charge et génératrice de courant de spin par effet spin-orbite ; et dans laquelle la paroi latérale externe du noyau interne, la paroi latérale interne et la paroi latérale externe de la couche isolante conductrice de spin, et la paroi latérale interne de la couche conductrice de courant de charge et génératrice de courant de spin par effet spin-orbite sont toutes à la fois biseautées et perpendiculaires par rapport à une surface horizontale d'un niveau d'interconnexion adjacent.

11. Structure de mémoire selon la revendication 1, dans laquelle la couche conductrice de courant de charge et génératrice de courant de spin par effet spin-orbite apporte une contribution à un flux de courant de charge chiral entourant le noyau interne de sorte à générer un courant de spin avec une polarisation de spin essentiellement en dehors du plan de la surface horizontale du noyau interne qui est en contact avec la structure de MTJ.

12. Structure de mémoire selon la revendication 1, dans laquelle la connexion de courant de charge entre le noyau interne et la couche conductrice de courant de charge et génératrice de courant de spin par effet spin-orbite permet un flux de courant de charge chiral dans la couche conductrice de courant de charge et génératrice de courant de spin par effet spin-orbite.

13. Structure de mémoire selon la revendication 1, dans laquelle la connexion de courant de charge entre le noyau interne et la couche conductrice de courant de charge et génératrice de courant de spin par effet spin-orbite est fournie par une quantité contrôlée de courant de perte à travers la couche isolante conductrice de spin à partir du noyau interne vers la couche conductrice de courant de charge et génératrice de courant de spin par effet spin-orbite, permettant une accumulation d'un flux de courant dans la couche conductrice de courant de charge et génératrice de courant de spin par effet spin-orbite pour former un courant de charge chiral.

14. Structure de mémoire selon la revendication 1, la couche conductrice de courant de charge et génératrice de courant de spin par effet spin-orbite est électriquement connectée à une première borne (22) et la structure de MTJ est électriquement connectée à une seconde borne (34).

15. Structure de mémoire comprenant :
une couche de matériau collecteur de spin (12) située dans un renfoncement (38) et le dessus d'une couche diélectrique d'interconnexion (18), une couche isolante conductrice de spin (14) située sur une paroi latérale de la couche de matériau collecteur de spin et une couche conductrice de courant de charge et génératrice de courant de spin par effet spin-orbite (16) située sur la couche isolante conductrice de spin ; et une structure de MTJ ayant une couche libre magnétique (26) formant une interface avec une surface de la couche de matériau collecteur de spin.
